# EUROPEAN PATENT APPLICATION

(11) **EP 4 661 079 A1**
(43) Date of publication of application: **10.12.2025**
(21) Application number: 25179225.5
(22) Date of filing: 27.05.2025
(51) Int. Cl.: H01L 23/522, H10D 1/68

(54) **PLANAR AND 3D CAPACITORS IN INTERCONNECT REGION**

(30) Priority: 30.05.2024 US 202418678787
(71) Applicant: INTEL Corporation, Santa Clara, CA 95054 (US)
(72) Inventor: FROST, Denzil S., Albuquerque, 87114 (US); JUN, Hwichan, Portland, 97229 (US); BOUCHE, Guillaume, Portland, 97217 (US); PARK, Changyok, Portland, 97229 (US); GUHA NEOGI, Tuhin, Sherwood, 97007 (US)
(74) Representative: 2SPL Patentanwälte PartG mbB

(57) **Abstract**

Techniques for forming one or more MIM trench capacitors over one or more planar MIM capacitors in an interconnect region above or below a device layer of an integrated circuit. The MIM trench capacitor(s) is in one or more interconnect layers of the interconnect region, and can have a relatively high height. The MIM trench capacitor includes a first electrode, a capacitor dielectric on the first electrode, and a second electrode on the capacitor dielectric, and runs along the outside surface of a plurality of dielectric fins, which increases the surface area of the capacitor within a relatively small plan footprint. A planar MIM capacitor is beneath the MIM trench capacitor within a same interconnect layer as the MIM trench capacitor. The planar MIM capacitor includes first and second planar electrodes separated by a capacitor dielectric, and may be electrically isolated from, or capacitively coupled to, the MIM trench capacitor.

## Description

### BACKGROUND

As integrated circuits continue to scale downward in size, a number of challenges arise. As density of devices increases, the available space on a given die dwindles rapidly. Some structures require a certain amount of space to operate effectively, but the limited available footprint on a die makes arranging these structures challenging. Accordingly, there remain a number of non-trivial challenges with respect to fabricating certain structures in an integrated circuit.

### BRIEF DESCRIPTION OF THE DRAWINGS

Figure 1 is a cross-sectional view that illustrates an example portion of an integrated circuit configured with an interconnect region over a plurality of semiconductor devices, in accordance with an embodiment of the present disclosure.
Figures 2A, 2B, 2C, and 2D are cross-sectional views of a metal-insulator-metal (MIM) trench capacitor above a planar MIM capacitor in an interconnect layer of the interconnect region, in accordance with some embodiments of the present disclosure.
Figures 3A and 3B are cross-sectional views that illustrate a first stage in an example process for forming a MIM trench capacitor above a planar MIM capacitor in the interconnect region, in accordance with some embodiments of the present disclosure.
Figures 4A and 4B are cross-sectional views that illustrate another stage in the example process for forming a MIM trench capacitor above a planar MIM capacitor in the interconnect region, in accordance with some embodiments of the present disclosure.
Figures 5A and 5B are cross-sectional views that illustrate another stage in the example process for forming a MIM trench capacitor above a planar MIM capacitor in the interconnect region, in accordance with some embodiments of the present disclosure.
Figures 6A and 6B are cross-sectional views that illustrate another stage in the example process for forming a MIM trench capacitor above a planar MIM capacitor in the interconnect region, in accordance with some embodiments of the present disclosure.
Figures 7A and 7B are cross-sectional views that illustrate another stage in the example process for forming a MIM trench capacitor above a planar MIM capacitor in the interconnect region, in accordance with some embodiments of the present disclosure.
Figures 8A and 8B are cross-sectional views that illustrate another stage in the example process for forming a MIM trench capacitor above a planar MIM capacitor in the interconnect region, in accordance with some embodiments of the present disclosure.
Figures 9A and 9B are cross-sectional views that illustrate another stage in the example process for forming a MIM trench capacitor above a planar MIM capacitor in the interconnect region, in accordance with some embodiments of the present disclosure.
Figures 10A and 10B are cross-sectional views that illustrate another stage in the example process for forming a MIM trench capacitor above a planar MIM capacitor in the interconnect region, in accordance with some embodiments of the present disclosure.
Figures 11A and 11B are cross-sectional views that illustrate another stage in the example process for forming a MIM trench capacitor above a planar MIM capacitor in the interconnect region, in accordance with some embodiments of the present disclosure.
Figures 12A and 12B are cross-sectional views that illustrate another stage in the example process for forming a MIM trench capacitor above a planar MIM capacitor in the interconnect region, in accordance with some embodiments of the present disclosure.
Figures 13A and 13B are cross-sectional views that illustrate another stage in the example process for forming a MIM trench capacitor above a planar MIM capacitor in the interconnect region, in accordance with some embodiments of the present disclosure.
Figure 14 is a plan view of an interconnect layer showing the arrangement of contacts for the MIM trench capacitor and the planar MIM capacitor, in accordance with some embodiments of the present disclosure.
Figure 15 is a cross-section view of a MIM trench capacitor above a planar MIM capacitor with the MIM trench capacitor spanning more than one interconnect layer, in accordance with some embodiments of the present disclosure.
Figure 16 is a cross-section view across example trenches for the MIM trench capacitor that include lateral cavities along the sidewalls of the trenches, in accordance with some embodiments of the present disclosure.
Figure 17 illustrates a cross-section view of a chip package containing one or more semiconductor dies, in accordance with an embodiment of the present disclosure.
Figure 18 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein for forming one or more MIM trench capacitors over one or more planar MIM capacitors in the interconnect region above or below the device layer of an integrated circuit. In some examples, the MIM trench capacitor(s) are formed within one of the upper interconnect layers (e.g., within one of the top three interconnect layers) of the interconnect region, and thus can have a relatively high height (e.g., greater than about 200 nm) and a large capacitance value. According to some such embodiments, an interconnect layer included in a stack of interconnect layers includes a MIM trench capacitor having a first electrode, a first capacitor dielectric on the first electrode, and a second electrode on the capacitor dielectric. The MIM trench capacitor runs along the outside surface of a plurality of dielectric fins, which greatly increases the surface area of the capacitor within a relatively small plan footprint. A planar MIM capacitor may be formed beneath or otherwise adjacent to the MIM trench capacitor within a same interconnect layer as the MIM trench capacitor. The planar MIM capacitor may include a planar third electrode and a planar fourth electrode separated by a second capacitor dielectric. Separate contacts may be made to each of the first, second, third, and fourth electrodes. In some cases, the MIM trench capacitor is electrically isolated from the planar MIM capacitor, while in other cases the MIM trench capacitor may be capacitively coupled to the planar MIM capacitor. Numerous configurations and variations will be apparent in light of this disclosure.

### General Overview

As previously noted above, it can be challenging to provide effective area scaling for capacitor structures. Passive metal-insulator-metal (MIM) capacitors protect against power delivery noise and can provide a charge reservoir close to the transistors. Their performance is measured in capacitance/area. Typical MIM capacitors stack electrode and high-K dielectric films in a planar two-dimensional (2D) fashion, which makes the capacitance directly dependent on the occupied 2D area. However, it becomes increasingly challenging to integrate such capacitors in densely packed devices with limited available footprint. Trench MIM capacitors extend in the z-direction as well as the x and y directions so as to provide a three-dimensional (3D) structure that increases capacitance without increasing the occupied 2D area. However, planar MIM capacitors can provide some advantages over 3D MIM capacitors. For example, 3D capacitor designs are less effective with high frequency signals compared to planar capacitor designs, even if they can store more charge.

Thus, techniques are provided herein for integrating both types of capacitors in a space-efficient way on a chip. Such examples include, for instance, forming MIM trench capacitors above planar MIM capacitors within the interconnect region above the semiconductor devices. The interconnect region includes a stack of interconnect layers having conductive structures for routing signal and/or power/ground rails between the various semiconductor devices. According to some embodiments, a MIM trench capacitor may be formed within one of the interconnect layers to free up more space in the device layer (e.g., where the semiconductor devices are located). The trench-based design of the MIM trench capacitor increases the capacitance due to the increase in surface area without causing a large increase in the 2D plan footprint of the capacitor. Additionally, a planar MIM capacitor may be provided beneath the trenches of the MIM trench capacitor to utilize the same 2D footprint for both capacitor designs. The planar MIM capacitor may be formed within a same interconnect layer as the MIM trench capacitor. In some embodiments, the MIM trench capacitor and the planar MIM capacitor are both formed within a single interconnect layer. In some other embodiments, the MIM trench capacitor extends through more than one interconnect layer (e.g., along a Z-direction). In some cases, the MIM trench capacitor is electrically isolated from the planar MIM capacitor, while in other cases the MIM trench capacitor may be capacitively coupled to the planar MIM capacitor. In some cases where they are capacitively coupled, the planar MIM capacitor may have relatively enhanced capacitance. In contrast, in some cases where they are decoupled, the planar MIM capacitor may have enhanced speed.

Any number of different contact designs may be used to form conductive contacts to the capacitor electrodes of each of the MIM trench capacitor and planar MIM capacitor. Topside contacts and/or vias extending down to bottom-side metal lines may be provided to make electrical contact with the different capacitor electrodes. In one example, capacitor electrodes of the MIM trench capacitor extend further along an X-direction to make contact with conductive contacts spaced away from the capacitor along the X-direction, and capacitor electrodes of the planar MIM capacitor extend further along a Y-direction to make contact with conductive contacts spaced away from the capacitor along the Y-direction.

According to an embodiment, an integrated circuit includes a plurality of semiconductor devices, an interconnect region above or below the plurality of semiconductor devices having a plurality of interconnect layers, a first MIM capacitor in at least one interconnect layer of the plurality of stacked interconnect layers, and a second MIM capacitor in one of the at least one interconnect layers. In some examples, the second MIM capacitor is below the first MIM capacitor. The first MIM capacitor includes a first electrode running along sidewalls and top surfaces of a plurality of parallel dielectric fins, a first capacitor dielectric layer on the first electrode such that the first capacitor dielectric layer follows the first electrode along the sidewalls and the top surfaces of the plurality of parallel dielectric fins, and a second electrode on the first capacitor dielectric layer such that the second electrode follows the first capacitor dielectric layer along the sidewalls and the top surfaces of the plurality of parallel dielectric fins. The second MIM capacitor includes a first planar electrode, a second capacitor dielectric layer on the first planar electrode, and a second planar electrode on the second capacitor dielectric layer.

According to another embodiment, an electronic device includes a chip package having one or more dies. At least one of the one or more dies includes an interconnect region above a plurality of semiconductor devices and having a plurality of interconnect layers, a first MIM capacitor in at least one interconnect layer of the plurality of interconnect layers, and a second MIM capacitor in one of the at least one interconnect layer. The first MIM capacitor includes a first electrode running along sidewalls and top surfaces of a plurality of parallel dielectric fins, a first capacitor dielectric layer on the first electrode such that the first capacitor dielectric layer follows the first electrode along the sidewalls and the top surfaces of the plurality of parallel dielectric fins, and a second electrode on the first capacitor dielectric layer such that the second electrode follows the first capacitor dielectric layer along the sidewalls and the top surfaces of the plurality of parallel dielectric fins. The second MIM capacitor is beneath the plurality of parallel dielectric fins and includes a first planar electrode, a second capacitor dielectric layer on the first planar electrode, and a second planar electrode on the second capacitor dielectric layer.

According to another embodiment, an integrated circuit includes an interconnect layer of a plurality of interconnect layers and having a dielectric layer, a first MIM capacitor embedded in the dielectric layer and having at least one electrode running along sidewalls and top surfaces of a plurality of parallel dielectric fins, and a second MIM capacitor embedded in the dielectric layer adjacent to the first MIM capacitor. The second MIM capacitor includes a first planar electrode, a second capacitor dielectric layer on the first planar electrode, and a second planar electrode on the second capacitor dielectric layer.

The techniques can be used with any type of planar and non-planar transistors, including finFETs (sometimes called double-gate transistors, or tri-gate transistors), nanowire and nanoribbon transistors (sometimes called gate-all-around transistors), and thin film transistors, to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a remove metal gate, or RMG, process). Any number of semiconductor materials can be used in forming the transistors to which power is being supplied by a buried or backside power rail, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of an accordion-like MIM trench capacitor within the interconnect region along with a planar MIM capacitor beneath the MIM trench capacitor in a same interconnect layer as the MIM trench capacitor. In some examples, the MIM capacitors may be located within one of the uppermost layers of the interconnect region (e.g., within the top three interconnect layers of the interconnect region). The MIM capacitors may be capacitively coupled to one another, or electrically isolated from one another.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

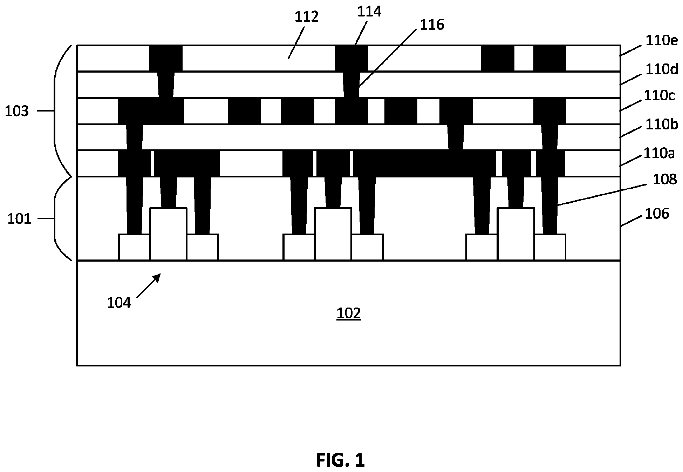

Figure 1 is a cross-sectional view that illustrates an example portion of an integrated circuit having an interconnect region above a plurality of semiconductor devices, in accordance with an embodiment of the present disclosure. The semiconductor devices in this example are non-planar metal oxide semiconductor (MOS) transistors, such as tri-gate or gate-all-around (GAA) transistors, although other transistor topologies and types can also benefit from the techniques provided herein, as will be appreciated (e.g., planar transistors, forksheet transistors, thin film transistors, or any other transistors to which contact can be made).

According to some embodiments, the integrated circuit includes a device region 101 (sometimes referred to as a device layer), and an interconnect region 103 over the device region 101. Device region 101 may include a plurality of semiconductor devices 104 along with one or more other layers or structures associated with the semiconductor devices 104. For example, device region 101 can also include one or more dielectric layers 106 that surround active portions or contacts of the semiconductor devices 104. Device region 101 may also include one or more conductive contacts 108 that provide electrical contact to transistor elements such as gate structures, drain regions, or source regions. Conductive contacts 108 include, for example, tungsten, although other metal or metal alloy materials may be used as well. Conductive contacts may also be a part of, or otherwise include, what is sometimes called a local interconnect, which is considered part of the device layer and usually formed prior to any backend processing.

In some embodiments, device region 101 is formed on or over a substrate 102. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, the substrate can be a semiconductor-on-insulator substrate having a desired semiconductor layer over a buried insulator layer (e.g., silicon over silicon dioxide). Alternatively, the substrate can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, backside processing is used to remove substrate 102 and form any number of backside interconnect layers.

Interconnect region 103 includes a plurality of interconnect layers 110a - 110e stacked over one another. Each interconnect layer can include a dielectric material 112 along with one or more different conductive features. Dielectric material 112 can be any dielectric, such as silicon oxide, silicon oxycarbide, silicon nitride, or silicon oxynitride. Dielectric material 112 may be deposited using any known dielectric deposition technique such as chemical vapor deposition (CVD), plasma-enhanced chemical vapor deposition (PECVD), flowable CVD, spin-on dielectric, or atomic layer deposition (ALD). The one or more conductive features can include conductive traces 114 and conductive vias 116 arranged in any pattern across the interconnect layers 110a - 110e to carry signal and/or power voltages to/from the various semiconductor devices 104. A conducive via, such as conductive via 116, may extend through an interconnect layer to connect between conductive traces on an upper interconnect layer and a lower interconnect layer. In other cases, a via 116 may only extend part way through a given interconnect layer. Although interconnect region 103 is illustrated with only five interconnect layers, any number of interconnect layers can be used within interconnect region 103. Also, this example shows vias and lines in different interconnect layers, in both single and dual damascene configurations. In other examples, vias and lines may also exist within the same interconnect layer, such as in the case of some dual damascene configurations.

Any of conductive traces 114 and conductive vias 116 can include any number of conductive materials, with some examples including copper, ruthenium, tungsten, cobalt, molybdenum, and alloys thereof. In some cases, any of conductive traces 114 and conductive vias 116 include a relatively thin liner or barrier, such as titanium nitride, titanium silicide, tungsten carbo-nitride (WCN), PVD or ALD tungsten, or tantalum nitride.

It should be noted that each of the various conductive vias 116 and conductive contacts 108 are shown with tapered profiles to indicate a more natural appearance due to the etching process used to form the openings. Any degree of tapering may be observed depending on the etch parameters used and the thickness of the dielectric layer being etched through. Furthermore, conductive vias may be stacked one over the other through different dielectric layers of interconnect region 103. However, in some examples, a single via recess may be formed through more than one dielectric layer yielding a taller, more tapered conductive via that extends through two or more dielectric layers.

The various interconnect layers of interconnect region 103 may not all be the same thickness. According to some embodiments, the interconnect layers increase in thickness moving upwards towards the top of interconnect region 103. Thus, the top-most interconnect layer may have the greatest thickness while the bottom-most interconnect layer may have the smallest thickness. In some examples, the top-most interconnect layer may have a thickness in the range of several micrometers (e.g., 1 - 4 µm), while the bottom-most interconnect layer may have a thickness of less than 50 nm.

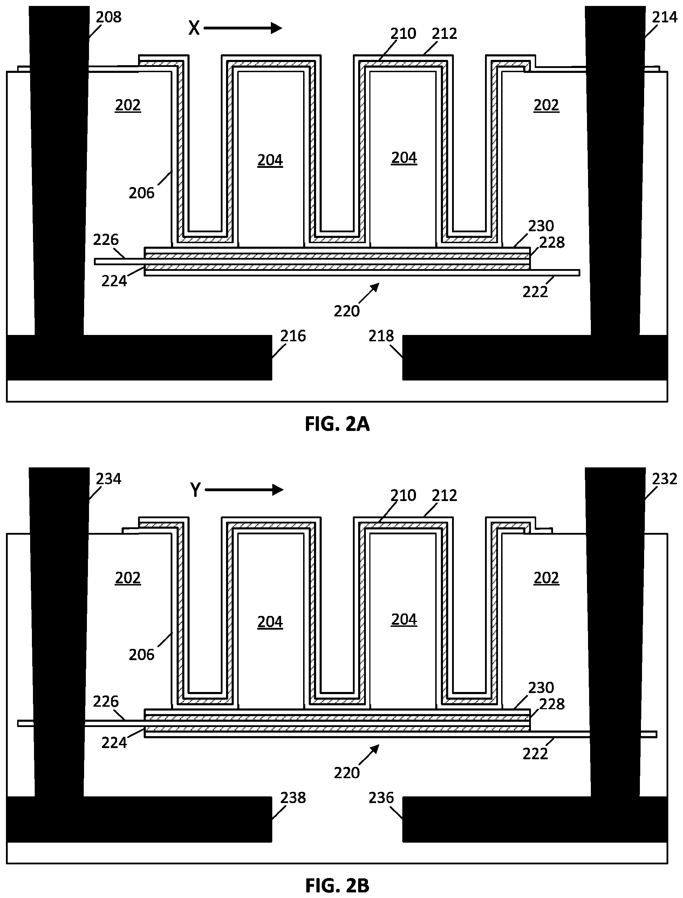

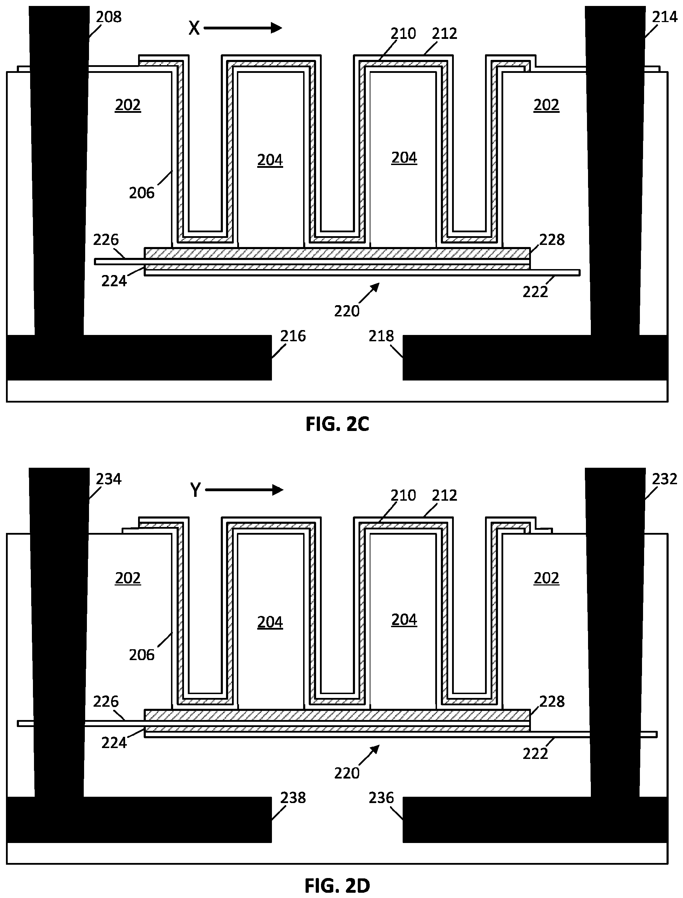

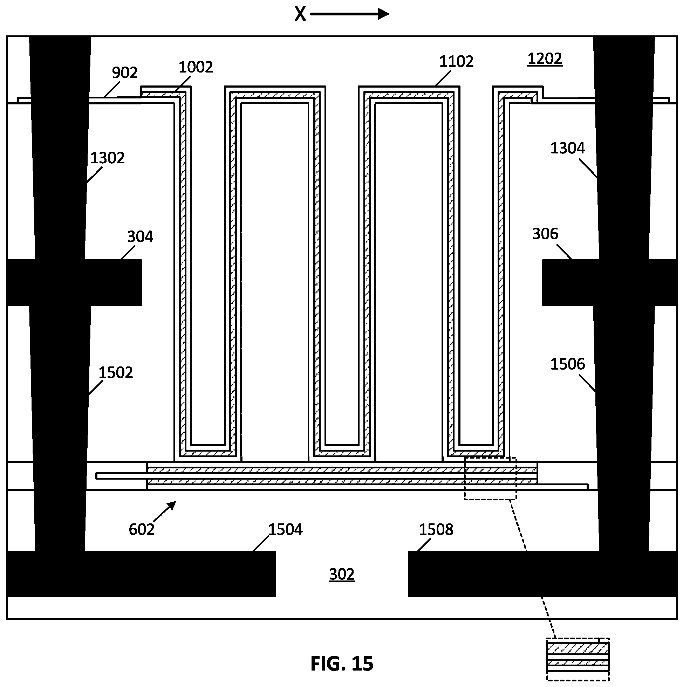

Any one of interconnect layers 110a - 110e may include MIM capacitor structures as variously described herein. The MIM capacitors may be in a single one of layers 110a - 110e (Figures 2A-2D), or may reside in multiple such layers (e.g., Figure 15). In some examples, the MIM capacitors reside in the uppermost layers of interconnect layers 110a - 110e, such as in one or more of interconnect layers 110c - 110e, so as to allow for relatively tall trench capacitors and relatively wide planar capacitors. Other examples may be configured differently or otherwise not call for taller trench capacitors and wider planar capacitors.

Figure 2A illustrates a more detailed cross-section view of a given interconnect layer having a MIM trench capacitor and a planar MIM capacitor formed within the interconnect layer, according to some embodiments. The cross-section of Figure 2A may be taken along the X-direction as indicated by the arrow. Figure 2B illustrates a cross-section of the MIM capacitors taken along the Y-direction, and thus orthogonal to the cross-section illustrated in Figure 2A. The interconnect layer may include a dielectric layer 202 having a thickness that defines the thickness of the interconnect layer. According to some embodiments, dielectric layer 202 has a total thickness, for example, of between about 400 nm and 4000 nm. Dielectric layer 202 may be any suitable dielectric material, such as silicon dioxide. In some examples, the illustrated interconnect layer may be one of the uppermost interconnect layers of frontside interconnect region 103. For example, the interconnect layer may be one of the top three interconnect layers of interconnect region 103. In some embodiments, more than one dielectric layer may be deposited to form the dielectric material of the interconnect layer. It should be understood that the illustrated interconnect layer may also be present, for example, within any one or more backside interconnect regions (e.g., below device region 101) or in an interposer.

Note that the illustrated interconnect layer can also include via structures and metal lines at other locations within the interconnect layer. Other features may also be included. For instance, there may be a relatively thin etch stop layer (e.g., silicon nitride having a thickness in the range of 2 nm to 6 nm) either along the top or bottom surface of dielectric layer 202 (or both top and bottom surfaces). Any number of configurations will be apparent in light of this disclosure.

According to some embodiments, a plurality of dielectric fins 204 are provided within dielectric layer 202. Dielectric fins 204 extend lengthwise into and out of the page to form recesses between them. According to some embodiments, dielectric fins 204 have a height, for example, between about 300 nm and about 2000 nm. Dielectric fins 204 may be formed directly from the dielectric material of dielectric layer 202 (e.g., formed via etching dielectric layer 202), or may be formed from patterning a different dielectric layer deposited on dielectric layer 202. A top surface of dielectric fins 204 may be substantially coplanar with a top surface of a remainder of dielectric layer 202.

The MIM trench capacitor includes a dielectric material sandwiched between two electrodes. According to some embodiments, the MIM trench capacitor includes a continuous structure that extends from a first location on the top surface of dielectric layer 202, and along the sidewall and top surfaces of each of the dielectric fins, to a second location on the top surface of dielectric layer 202. In the example case shown, a first electrode 206 continuously runs along the sidewalls and top surfaces of dielectric fins 204. First electrode 206 may also contact a top surface of dielectric layer 202 beyond the recesses, as part of its continuous nature. According to some such embodiments, first electrode 206 extends further along the X-direction on the top surface of dielectric layer 202 on one side of the plurality of recesses compared to the other side. The extended portion or tail of first electrode 206 provides a landing site (or through point) for a first topside contact 208, according to some embodiments. First topside contact 208 may include any suitable conductive material, such as tungsten, ruthenium, titanium, tantalum, cobalt, molybdenum, or copper.

First electrode 206 may be any suitable conductive material, such as tungsten, titanium, titanium nitride, ruthenium, cobalt, molybdenum, or copper. First electrode 206 may directly contact the dielectric material of dielectric fins 204 and dielectric layer 202, or a different material may be interposed between first electrode 206 and dielectric fins 204/dielectric layer 202. For example, a barrier layer including tantalum or titanium may be between first electrode 206 and the dielectric material of dielectric fins 204/dielectric layer 202. In another example, a different dielectric layer, such as silicon nitride, may be present between first electrode 206 and the dielectric material of dielectric fins 204/dielectric layer 202. First electrode 206 may have any suitable thickness depending on the application. In some examples, first electrode 206 has a thickness, for instance, between about 10 nm and about 50 nm, or between about 20 nm and about 100 nm.

According to some embodiments, a first dielectric structure 210 is on first electrode 206 at least within the recesses adjacent to dielectric fins 204. In some examples, first dielectric structure 210 follows first electrode 206 along the sidewalls and top surfaces of dielectric fins 204. In some embodiments, first dielectric structure 210 also follows at least a portion of first electrode 206 onto a top surface of dielectric layer 202 on either or both sides of the plurality of trenches, as part of its continuous nature. First dielectric structure 210 may represent one or more dielectric layers that make up the capacitor dielectric. According to some embodiments, first dielectric structure 210 includes at least one high-k dielectric material, such as a material with a dielectric constant equal to or greater than that of silicon nitride. In one example, first dielectric structure 210 includes a layer of hafnium oxide, aluminum oxide, or zirconium oxide. First dielectric structure 210 may have any suitable thickness depending on the application. In some examples, first dielectric structure 210 has a thickness, for instance, between about 2 nm and about 10 nm.

According to some embodiments, a second electrode 212 is on first dielectric structure 210 at least within the recesses adjacent to dielectric fins 204. In some examples, second electrode 212 follows first dielectric structure 210 along the sidewalls and top surfaces of dielectric fins 204. Second electrode 212 may also contact a top surface of dielectric layer 202 beyond the trenches, as part of its continuous nature. According to some embodiments, second electrode 212 extends further along the X-direction on the top surface of dielectric layer 202 on one side of the plurality of trenches compared to the other side. The extended portion or tail of second electrode 212 provides a landing site for a second topside contact 214, according to some embodiments. Second topside contact 214 may have similar properties to first topside contact 208. Second electrode 212 may be any suitable conductive material, such as tungsten, titanium, titanium nitride, ruthenium, cobalt, molybdenum, or copper. In the illustrated example, first electrode 206 extends further on the top surface of dielectric layer 202 on the left side of the plurality of trenches and second electrode 212 extends further on the top surface of dielectric layer 202 on the right side of the plurality of trenches. Due to the sandwich layout with first dielectric structure 210, second electrode 212 is separated from first electrode 206 by dielectric structure 210. Second electrode 212 may have any suitable thickness. In some examples, second electrode 212 has a thickness, for instance, between about 10 nm and about 50 nm, or between about 20 nm and about 100 nm.

According to some embodiments, each of topside contacts 208 and 214 are via structures formed through at least a portion of a thickness of dielectric layer 202 to contact conductive traces 216 and 218, respectively. According to some embodiments, first topside contact 208 provides a conductive path between first electrode 206 and conductive trace 216 and second topside contact 214 provides a conductive path between second electrode 212 and conductive trace 218. Other contact designs may be used as well to provide electrical contact with each of first electrode 206 and second electrode 212.

Due to the continuous nature of the MIM trench capacitor extending from a first location on dielectric layer 202, and following the shape of the recesses, to a second location on the dielectric layer 202, the MIM trench capacitor has a three-dimensional serpentine or accordion shape that increases the surface area between the electrodes within a relatively small two-dimensional footprint, thus requiring less space in the X-direction (left to right on the page in Figure 2A) and/or in the Y-direction (left to right on the page in Figure 2B). Likewise, another example configuration may use less space in the Z-direction (up and down the page) if more space is used in the X and/or Y directions. Other such variations can be used as well, so as to provide a capacitor structure with a relatively high amount of capacitance, compared to a planar capacitor.

According to some embodiments, a planar MIM capacitor 220 is arranged beneath the MIM trench capacitor. The planar MIM capacitor may include a third electrode 222, a second dielectric structure 224 on third electrode 222, and a fourth electrode 226 on dielectric structure 224. Each of third electrode 222, second dielectric structure 224, and fourth electrode 226 may be planar material layers. Like first electrode 206 and second electrode 212, third electrode 222 and fourth electrode 226 may include any suitable conductive material, such as tungsten, titanium, titanium nitride, ruthenium, cobalt, molybdenum, or copper, and may have a thickness, for example, between about 10 nm and about 50 nm, or between about 20 nm and about 100 nm. Second dielectric structure 224 may also have a similar material composition and/or structure as first dielectric structure 210 or include any of the other high-k materials described above.

According to some embodiments, planar MIM capacitor 220 is separated from first electrode 206 of the MIM trench capacitor by a dielectric layer 228 and a conductive layer 230, as shown in Figures 2A-B. Conductive layer 230 may be generally any conductive material or any etch stop material to set the etch depth for forming the recesses, as further described below. In some examples, conductive layer 230 directly contacts a bottom surface(s) of first electrode 206 at the bottom of the recesses, and dielectric layer 228 directly contacts a top surface of fourth electrode 226.

In some cases, conductive layer 230 and dielectric layer 228 may be configured to capacitively couple the planar MIM capacitor 220 to the MIM trench capacitor. In such a case, the planar MIM capacitor 220 may have relatively enhanced capacitance, albeit at the expense of some speed. In some such cases, conductive layer 230 may include any suitable conductive material such as, for instance, tungsten, ruthenium, cobalt, molybdenum, or copper, and may have a thickness, for example, between about 10 nm and about 50 nm, or between about 20 nm and about 100 nm; and dielectric layer 228 may include a high-k dielectric material such as, for instance, hafnium oxide, aluminum oxide, or zirconium oxide (or a same material as dielectric structures 210 and 224), and may have a thickness, for example, between about 10 nm and about 50 nm, or between about 20 nm and about 100 nm. In still other such cases having both dielectric layer 228 and conductive layer 230, dielectric layer 228 can be configured to inhibit capacitive coupling. In such a case, the planar MIM capacitor may have relatively enhanced speed, albeit at the expense of some capacitance. For instance, dielectric layer 228 can be made thicker (e.g., greater than 100 nm, or greater than 200 nm) and/or comprise medium to low-k dielectric (e.g., silicon dioxide or porous silicon dioxide). In any such cases, conductive layer 230 can be configured to provide an etch stop effect to facilitate forming trenches for the MIM trench capacitor.

In still other examples, only dielectric layer 228 is provided and there is no conductive layer 230. In such cases, dielectric layer 228 can be configured to either allow for capacitive coupling between the planar MIM capacitor 220 to the MIM trench capacitor, or electrically isolate the planar MIM capacitor 220 from the MIM trench capacitor. Such examples are shown in Figures 2C-D. As shown, dielectric layer 228 directly contacts a bottom surface(s) of first electrode 206 at the bottom of the recesses and also directly contacts a top surface of fourth electrode 226. Dielectric layer 228 may be one or more layers of dielectric material (e.g., a single layer of silicon nitride or other suitable dielectric material, or a bi-layer structure that includes, for instance, a layer of silicon dioxide on fourth electrode 226 and a layer of silicon nitride on the layer of silicon dioxide). For capacitive coupling, dielectric layer 228 can be relatively thin (e.g., between about 10 nm and about 50 nm, or between about 20 nm and about 200 nm) and have a relatively high dielectric constant (e.g., hafnium oxide, aluminum oxide, zirconium oxide, or a same material as dielectric structures 210 and 224). For electrical isolation, on the other hand, dielectric layer 228 can be relatively thick (e.g., greater than 200 nm) and may have a medium or relatively low dielectric constant (e.g., silicon nitride, silicon oxynitride, or silicon carbonitride). In any such cases, dielectric layer 228 can be configured to provide an etch stop effect to facilitate forming trenches for the MIM trench capacitor. In this manner, the upper surface of dielectric layer 228 may be etch selective to the etch chemistry used to form the dielectric fins, and thus resist that etch scheme.

With further reference to the examples of Figures 2A-D, third electrode 222 extends further along the Y-direction on one side of planar MIM capacitor 220 compared to the other side. The extended portion or tail of third electrode 222 may intersect or otherwise contact a third topside contact 232, according to some embodiments. Similarly, fourth electrode 226 may extend further along the Y-direction on the opposite side of planar MIM capacitor 220. The extended portion or tail of fourth electrode 226 may intersect or otherwise contact a fourth topside contact 234, according to some embodiments. Each of topside contacts 232 and 234 may be via structures formed through at least a portion of a thickness of dielectric layer 202 to contact conductive traces 236 and 238, respectively. According to some embodiments, third topside contact 232 provides a conductive path between third electrode 222 and conductive trace 236 and fourth topside contact 234 provides a conductive path between fourth electrode 226 and conductive trace 238. Other contact designs may be used as well to provide electrical contact with each of third electrode 222 and fourth electrode 226.

It should be understood that any number of trench capacitors can be formed within the recesses between dielectric fins 204. For example, additional capacitor dielectric layers and electrodes may be formed over second electrode 212 to form any number of 3D trench capacitors within the same recesses. Similarly, any number of planar capacitors can be formed by forming additional planar dielectric layers and planar electrodes. Additional contacts may be formed to each of the additional planar electrodes and 3D electrodes. In some embodiments, each of the 3D capacitors may be connected in parallel using the same first topside contact 208 and second topside contact 214, and each of the planar capacitors may be connected in parallel using the third topside contact 232 and fourth topside contact 234.

### Fabrication Methodology

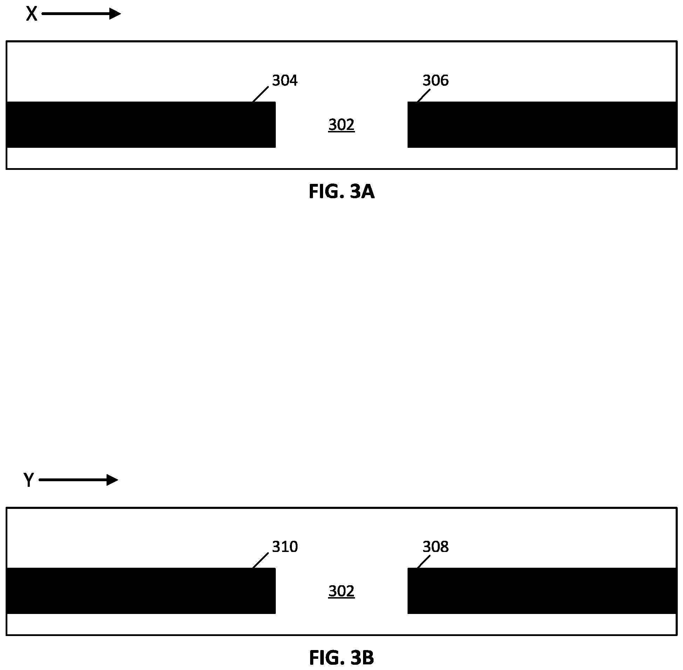

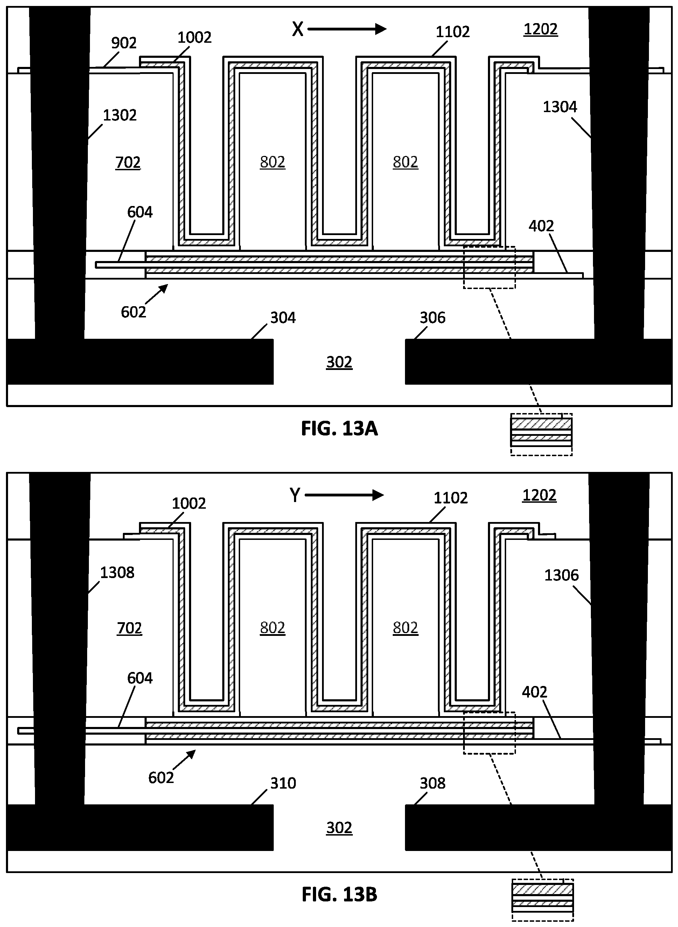

Figures 3A - 13A and 3B - 13B include cross-sectional views across orthogonal directions that collectively illustrate an example process for forming an integrated circuit with a trench MIM capacitor and planar MIM capacitor integrated into a same region of an interconnect layer, in accordance with an embodiment of the present disclosure. Figures 3A - 13A represent a similar cross-sectional view as that of Figure 2A (e.g., along an X-direction), while Figures 3B - 13B represent a similar cross-sectional view as that of Figure 2B (e.g., along a Y-direction). Each set of figures sharing the same letter shows an example structure that results from the process flow up to that point in time, so the depicted structure evolves as the process flow continues, culminating in the structure shown in Figures 13A - 13B, which is similar to the structure shown in Figures 2A and 2B. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figures 3A and 3B are a cross sectional views taken through an interconnect layer of a plurality of stacked interconnect layers. Accordingly, the illustrated interconnect layer may be at any position within interconnect region 103. As noted above, the illustrated interconnect layer may be one of the upper interconnect layers, such as one of the top three interconnect layers of interconnect region 103. The interconnect layer includes a dielectric layer 302 that may include any suitable dielectric material, such as silicon dioxide, silicon oxynitride, or silicon oxycarbide. Dielectric layer 302 may be formed using any known dielectric deposition technique, such as CVD, PECVD, flowable CVD, spin-on dielectric, or ALD. Dielectric layer 302 may have a height between about 400 nm and about 4000 nm.

According to some embodiments, the illustrated interconnect region includes one or more conductive traces. For example, a first conductive trace 304 and a second conductive trace 306 may be provided that extend along the X-direction within or otherwise on dielectric layer 302. Similarly, a third conductive trace 308 and a fourth conductive trace 310 may be provided that extend along the Y-direction within or otherwise on dielectric layer 302. Each of the conductive traces may include any suitable conductive material, such as copper, tungsten, ruthenium, cobalt, or molybdenum, to name a few examples.

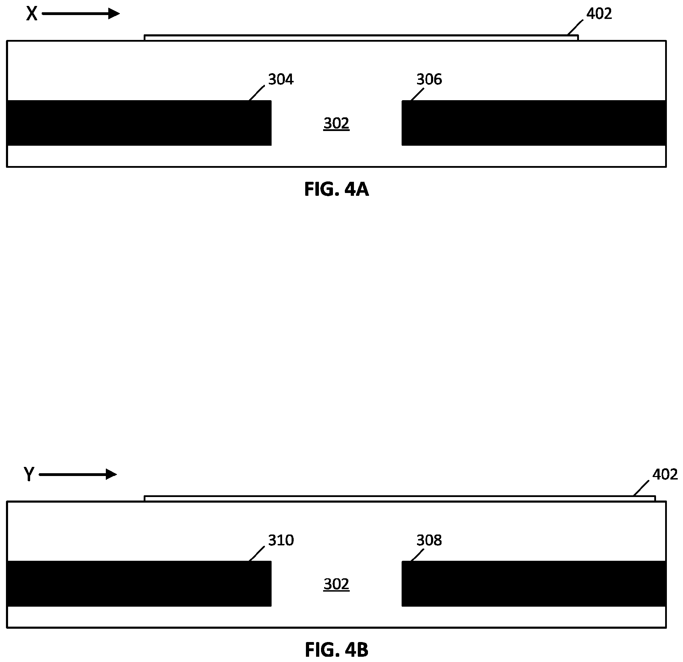

Figures 4A and 4B depict the cross-section views of the structure shown in Figures 3A and 3B, respectively, following the formation of a first planar electrode 402, according to some embodiments. Any suitable lithography techniques may be used to pattern first planar electrode 402 on the surface of dielectric layer 302. First planar electrode 402 may be a conductive layer of a suitable metal material, such as any of copper, tungsten, titanium, titanium nitride, ruthenium, cobalt, or molybdenum, to name a few examples. In some examples, first planar electrode 402 includes titanium nitride. First planar electrode 402 may be deposited using any one of electroplating, electroless plating, CVD, or PECVD, to name a few examples. Note that first planar electrode 402 may extend further along one direction compared to the orthogonal direction (e.g., providing a rectangular plate). In the illustrated example, first planar electrode 402 extends further along the Y-direction compared to the X-direction. According to some embodiments, first planar electrode 402 is deposited to a thickness between about 20 nm and about 100 nm.

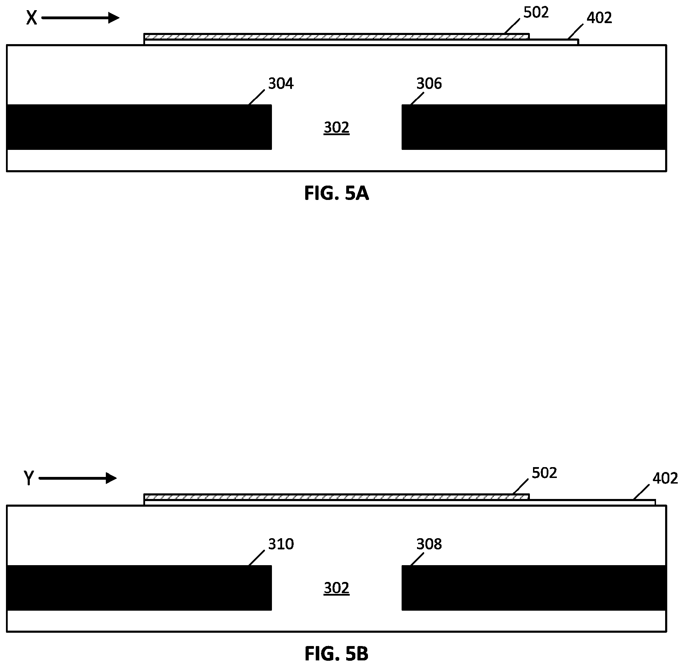

Figures 5A and 5B depict the cross-section views of the structure shown in Figures 4A and 4B, respectively, following the formation of a planar capacitor dielectric layer 502, according to some embodiments. Capacitor dielectric layer 502 may represent any number of deposited dielectric layers. In some examples, capacitor dielectric layer 502 includes a layer of hafnium oxide, aluminum oxide, zirconium oxide, or any other suitable high-k dielectric material. Capacitor dielectric layer 502 may be deposited using any suitable dielectric deposition technique, such as CVD, PECVD, ALD, or spin-on dielectric. In some embodiments, capacitor dielectric layer 502 is patterned using suitable lithography techniques such that it remains over only a portion of first electrode 402. For example, first electrode 402 may include a tail that extends out from capacitor dielectric layer 502 along the Y-direction.

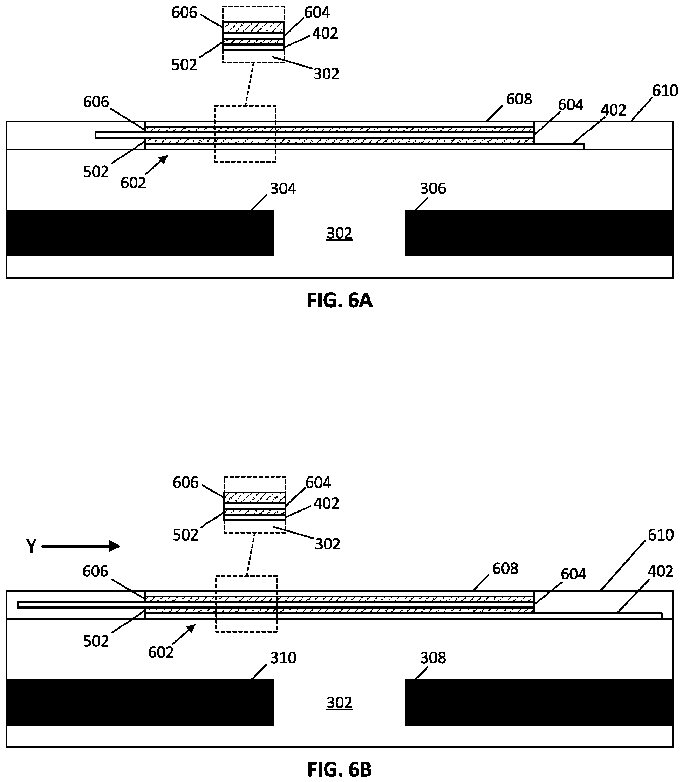

Figures 6A and 6B depict the cross-section views of the structure shown in Figures 5A and 5B, respectively, following the formation of any number of additional alternating conductive layers and dielectric layers to form one or more planar MIM capacitors, according to some embodiments. In the illustrated example, a planar MIM capacitor 602 includes first planar electrode 402, capacitor dielectric layer 502, and a second planar electrode 604. According to some embodiments, second planar electrode 604 may include the same conductive material as first planar electrode 402. In some examples, second planar electrode 604 includes titanium nitride. Second planar electrode 604 may extend further in the opposite direction along the Y-direction compared to first planar electrode 402, as seen in Figure 6B. According to some embodiments, second planar electrode 604 is deposited to a thickness between about 20 nm and about 100 nm.

According to some embodiments, another dielectric layer 606 may be formed over second planar electrode 604. Dielectric layer 606 may include, for example, a high-k material, such as the same high-k material included in capacitor dielectric layer 502. In other examples, dielectric layer 606 includes any electrically insulating dielectric material, such as silicon dioxide, silicon nitride, or silicon oxynitride, to name a few examples. According to some embodiments, a material layer 608 is formed over dielectric layer 606. In some examples, material layer 608 is a conductive layer, such as a metal layer. Material layer 608 may include the same conductive material as first planar electrode 402 and second planar electrode 604. In some examples, material layer 608 includes a material that is suitable for use as an etch stop layer during reactive ion etching (RIE) of silicon dioxide.

As described above, layers 606 and 608 can be configured to capacitively couple planar MIM capacitor 602 to an above-formed trench capacitor structure, or to electrically isolate those two capacitors. In other examples, such as shown in the dashed pull-out square, there is only dielectric layer (or structure) 606 and no layer 608, as described above with reference to Figures 2C-D, and that previous description is equally applicable here. Such a dielectric layer 606 also can be configured to either capacitively couple planar MIM capacitor 602 to an above-formed trench capacitor, or electrically isolate planar MIM capacitor 602 from the above-formed trench capacitor.

A dielectric structure 610 may be formed around planar MIM capacitor 602 and any of the one or more planar material layers formed over planar MIM capacitor 602, according to some embodiments. Dielectric structure 610 may include any number of dielectric layers formed during the fabrication of the various material layers to maintain a planar top surface. For example, dielectric material may be deposited and polished following the formation of each of the planar material layers 402, 502, 604, 606, and 608 (if present), or following the formation of any sets of the planar material layers. Dielectric structure 610 may include any suitable dielectric material, such as silicon dioxide, silicon nitride, or silicon oxynitride. In some examples, dielectric structure 610 includes the same dielectric material as dielectric layer 302.

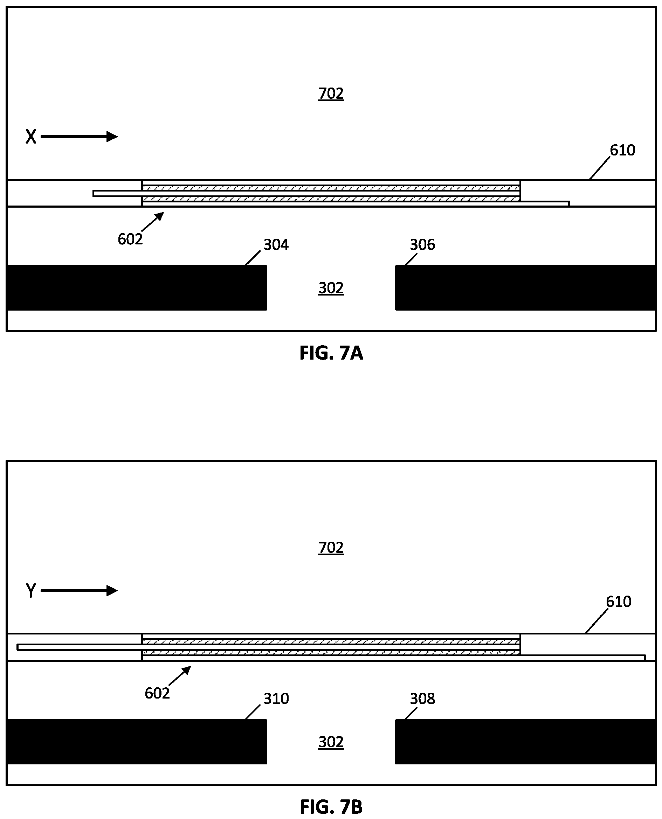

Figures 7A and 7B depict the cross-section views of the structure shown in Figures 6A and 6B, respectively, following the formation of a relatively thick dielectric layer 702, according to some embodiments. Dielectric layer 702 may include any suitable dielectric material, such as silicon dioxide, silicon nitride, or silicon oxynitride. In some examples, dielectric layer 702 includes the same dielectric material as dielectric layer 302 and/or dielectric structure 610. Dielectric layer 702 may have a thickness between about 200 nm and about 2000 nm, depending on the desired size of the MIM trench capacitor to be formed above planar MIM capacitor 602.

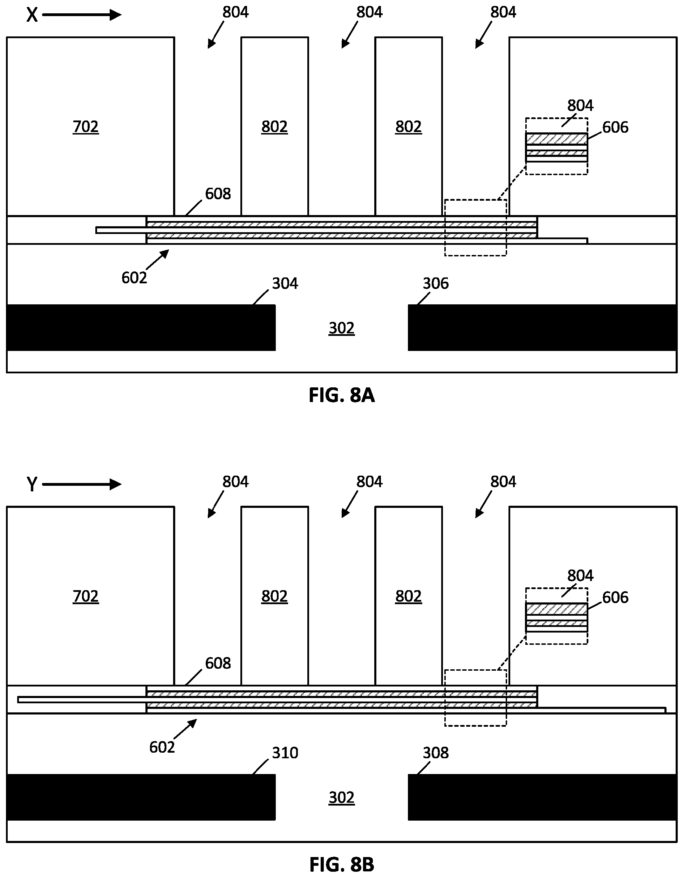

Figures 8A and 8B depict the cross-section views of the structure shown in Figures 7A and 7B, respectively, following the formation of a plurality of parallel fins 802 within dielectric layer 702, according to some embodiments. An etching process may be performed using a patterned mask to protect some areas of dielectric layer 702 while exposing other areas to be recessed via the etch. Any suitable anisotropic etching process, such as RIE, may be used to form recesses 804 within dielectric layer 702. Dielectric fins 802 (and similarly recesses 804) may extend the entire thickness of dielectric layer 702 (e.g., having a height between about 300 nm and about 2000 nm). In some other embodiments, recesses 804 extend through only a portion of the total thickness of dielectric layer 702. According to some embodiments, recesses 804 may have a substantially constant pitch from one another along both the X and Y directions. According to some embodiments, a top surface of material layer 608 is exposed at the bottom of recesses 804. Thus, material layer 608 may act as an etch stop for the RIE process to protect the underlying planar MIM capacitor 602. In another example shown in the dashed pull-out square, there is only dielectric layer (or structure) 606 and no layer 608, as described above with reference to Figures 2C-D and 6A-B, and that previous description is equally applicable here.

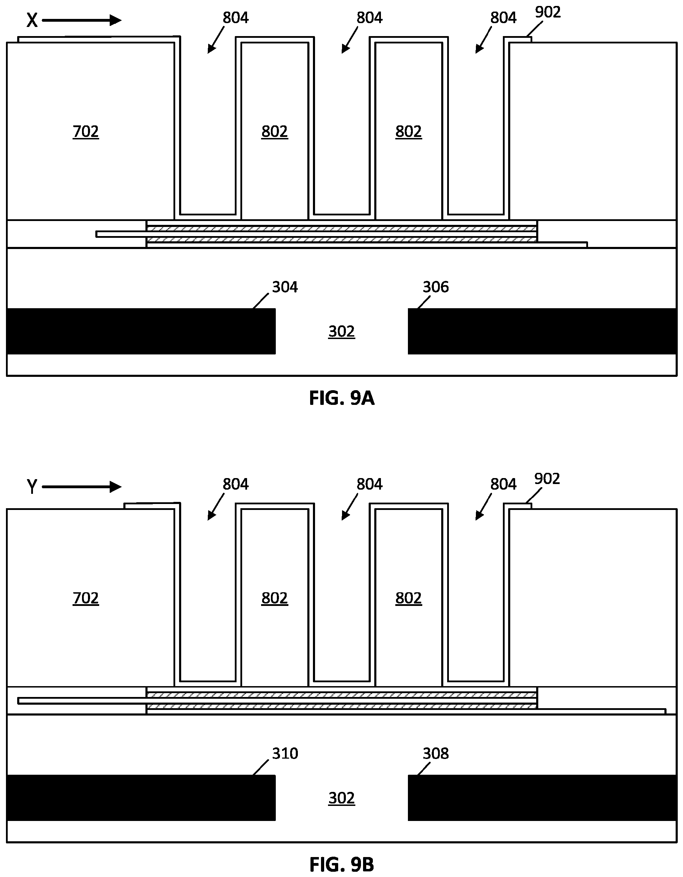

Figures 9A and 9B depict the cross-section views of the structure shown in Figures 8A and 8B, respectively, following the formation of a first trench electrode 902, according to some embodiments. First trench electrode 902 may include copper or tungsten that is deposited using any one of electroplating, electroless plating, CVD, or PECVD, to name a few examples. Any other suitable conductive materials may be used as well (e.g., aluminum, titanium, titanium nitride, ruthenium, cobalt, molybdenum). According to some embodiments, first trench electrode 902 is deposited directly on all surfaces within recesses 804 as well as on the top surfaces of fins 802 and dielectric layer 702. In some other embodiments, a barrier layer or other dielectric layer is first deposited on the exposed surfaces of fins 802 and recesses 804, and first trench electrode 902 is deposited onto the barrier layer or other dielectric layer.

According to some embodiments, first trench electrode 902 is patterned using any suitable lithography process such that first trench electrode 902 extends further along the X-direction on the top surface of dielectric layer 702 on one side of the plurality of fins 802 compared to the opposite side. In the illustrated example, the left side of first trench electrode 902 extends further on the top surface of dielectric layer 702 compared to the right side of first trench electrode 902. According to some embodiments, first trench electrode 902 is deposited to a thickness between about 20 nm and about 100 nm.

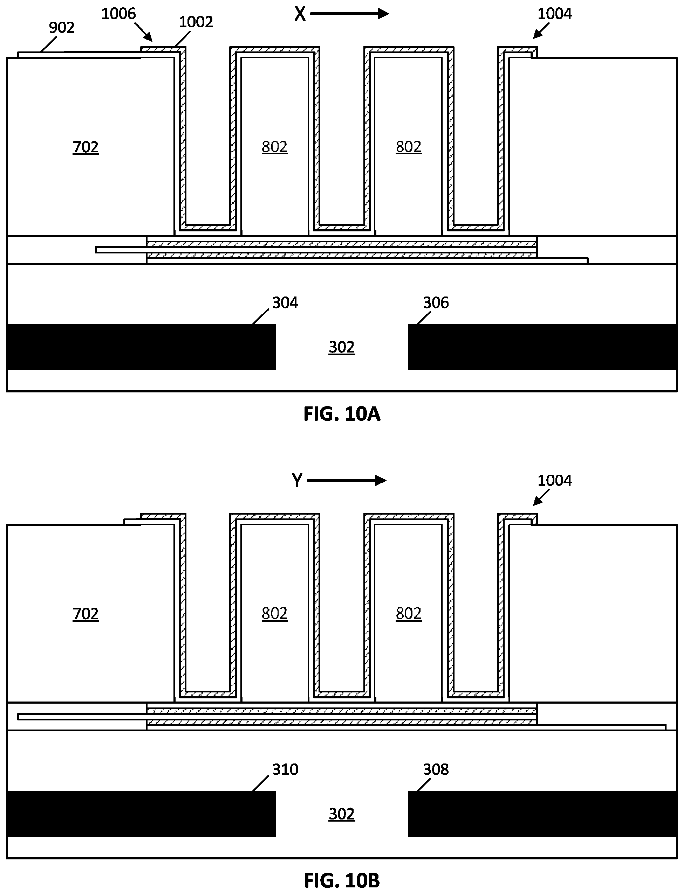

Figures 10A and 10B depict the cross-section views of the structure shown in Figures 9A and 9B, respectively, following the formation of a trench dielectric structure 1002 on first trench electrode 902, according to some embodiments. Trench dielectric structure 1002 may represent any number of deposited dielectric layers. In some examples, trench dielectric structure 1002 includes an aluminum zirconium alloy or any other suitable high-k dielectric material. Trench dielectric structure 1002 may be deposited using any suitable dielectric deposition technique, such as CVD, PECVD, ALD, or spin-on dielectric.

According to some embodiments, trench dielectric structure 1002 follows first trench electrode 902 over all surfaces within recesses 804 and over fins 802. Trench dielectric structure 1002 may be patterned using any suitable lithographic technique such that trench dielectric structure 1002 completely covers the shorter side of first trench electrode 902 (e.g., at location 1004) on the top surface of dielectric layer 702 and exposes a portion of the longer side of first trench electrode 902 (e.g., at location 1006) on the top surface of dielectric layer 702. According to some embodiments, trench dielectric structure 1002 is deposited to a thickness between about 20 nm and about 100 nm.

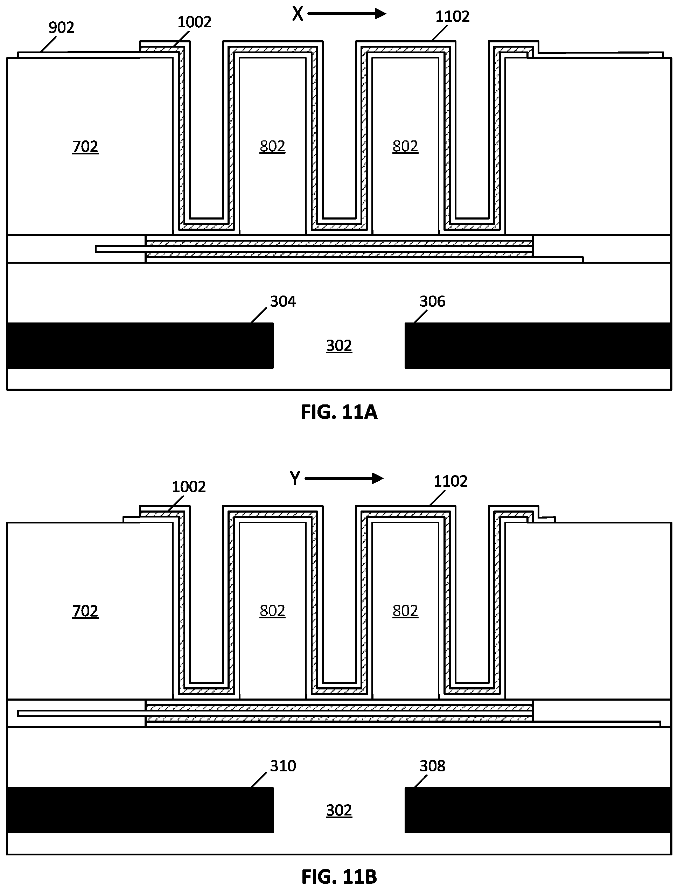

Figures 11A and 11B depict the cross-section views of the structure shown in Figures 10A and 10B, respectively, following the formation of a second trench electrode 1102 on trench dielectric structure 1002, according to some embodiments. Second trench electrode 1102 may include copper or tungsten that is deposited using any one of electroplating, electroless plating, CVD, or PECVD, to name a few examples. Any other suitable conductive materials may be used as well (e.g., aluminum, titanium, titanium nitride, ruthenium, cobalt, molybdenum). In some examples, first trench electrode 902 and second trench electrode 1102 include the same conductive material. According to some embodiments, second trench electrode 1102 follows trench dielectric structure 1002 over all surfaces within recesses 804 and over fins 802.

According to some embodiments, second trench electrode 1102 is patterned using any suitable lithography process such that second trench electrode 1102 extends further along the X-direction on the top surface of dielectric layer 702 on one side of the plurality of fins 802 compared to the opposite side. In the illustrated example, the right side of second trench electrode 1102 extends further on the top surface of dielectric layer 702 compared to the left side of second trench electrode 1102. In the illustrated example, first trench electrode 902 extends further on the top surface of dielectric layer 702 on one side of the plurality of recesses 804 and second trench electrode 1102 extends further on the top surface of dielectric layer 702 on the opposite side of the plurality of recesses 804. Due to the sandwich layout with trench dielectric structure 1002, second trench electrode 1102 is separated from first trench electrode 902 by trench dielectric structure 1002 along all surfaces within recesses 804 and on fins 802. According to some embodiments, second trench electrode 1102 is deposited to a thickness between about 20 nm and about 100 nm.

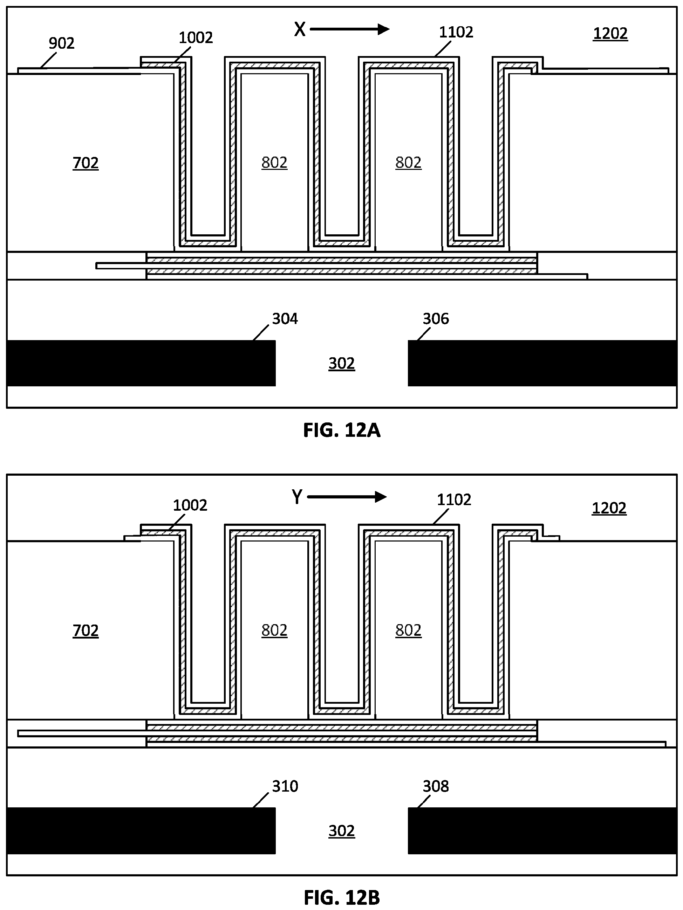

Figures 12A and 12B depict the cross-section views of the structure shown in Figures 11A and 11B, respectively, following the formation of an additional dielectric layer 1202 over dielectric layer 702, according to some embodiments. Dielectric layer 1202 may include any suitable dielectric material, such as the same dielectric material as dielectric layer 702. According to some embodiments, dielectric layer 1202 fills in any remaining space within recesses 804 following the formation of the MIM trench capacitor structure. A top surface of dielectric layer 1202 may be planarized using any standard polishing technique, such as chemical mechanical polishing (CMP).

Figures 13A and 13B depict the cross-section views of the structure shown in Figures 12A and 12B, respectively, following the formation of contacts 1302/1304/1306/1308 through dielectric layer 702, according to some embodiments. According to some embodiments, each of contacts 1302 - 1308 extends through any number of dielectric layers to contact a corresponding one of conductive traces 304 - 310. For example, a first contact 1302 provides a conductive connection between first trench electrode 902 and first conductive trace 304, a second contact 1304 provides a conductive connection between second trench electrode 1102 and second conductive trace 306, a third conductive contact 1306 provides a conductive connection between first planar electrode 402 and third conductive trace 308, and a fourth conductive contact 1308 provides a conductive connection between second planar electrode 604 and fourth conductive trace 310.

Any of Contacts 1302 - 1308 may include any suitable conductive material, such as tungsten, copper, cobalt, ruthenium, or molybdenum. In some examples, contacts 1302 - 1308 include a barrier layer having titanium or tantalum that is deposited first and followed by a metal fill formed on the barrier layer. It should be understood that electrical connection to each of the various capacitor electrodes may also be made from above the capacitors rather than using conductive traces 304 - 310 below the capacitors. In such examples, first contact 1302 may only extend down to first trench electrode 902, second contact 1304 may only extend down to second trench electrode 1102, third contact 1306 may only extend down to first planar electrode 402, and fourth contact 1308 may only extend down to second planar electrode 604. Other contact schemes will be appreciated. In another example shown in the dashed pull-out square, there is only dielectric layer (or structure) 606 and no layer 608, as described above with reference to Figures 2C-D, 6A-B, and 8A-B, and that previous description is equally applicable here.

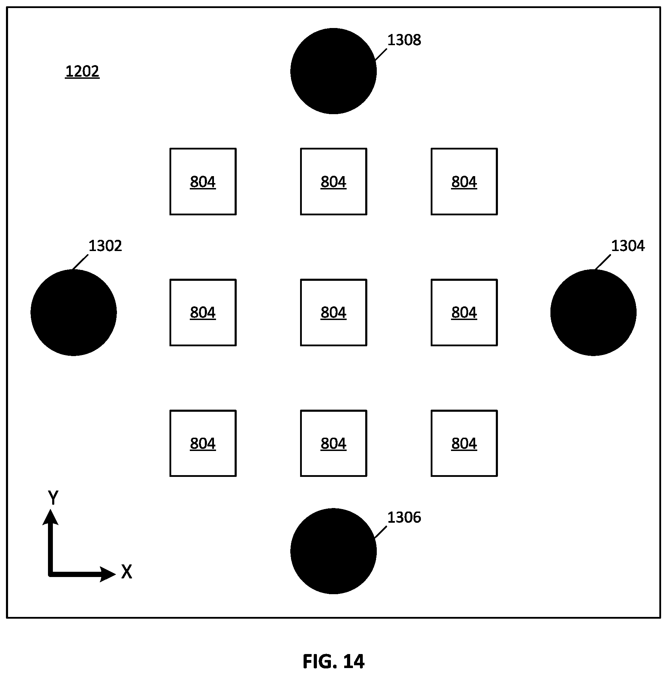

Figure 14 illustrates a plan view of the integrated circuit to show general locations of contacts 1302 - 1308, according to some embodiments. The locations of recesses 804 are also illustrated to demonstrate one example layout of such recesses 804 when forming the MIM trench capacitor. Recesses 804 may be arranged in any number of rows and columns and may have a staggered arrangement between different rows and/or columns. First contact 1302 and second contact 1304 may be arranged on opposite sides of the capacitors along the X-direction to contact the electrodes of the MIM trench capacitor while third contact 1306 and fourth contact 1308 may be arranged on opposite sides of the capacitors along the Y-direction to contact the electrodes of the planar MIM capacitor.

Figure 15 illustrates a cross section view of a MIM trench capacitor that extends through more than one interconnect layer, according to some embodiments. In an example, the recesses of the MIM trench capacitor extend below first and second conductive traces 304 and 306, and contact is made between first trench electrode 902 and second trench electrode 1102 to conductive traces in a lower interconnect layer. According to some embodiments, a first additional contact 1502 extends between first conductive trace 304 and an first additional conductive trace 1504 while a second additional contact 1506 extends between second conductive trace 306 and a second additional conductive trace 1508. Similar contact schemes can be used to connect to the planar electrodes of the planar MIM capacitor 602. In some embodiments, a first single conductive contact may be used to extend the entire height between first trench electrode 902 and first additional conductive trace 1504, and a second single conductive contact may be used to extend the entire height between second trench electrode 1102 and second additional conductive trace 1508. The trench MIM capacitor may extend through any number of interconnect layers.

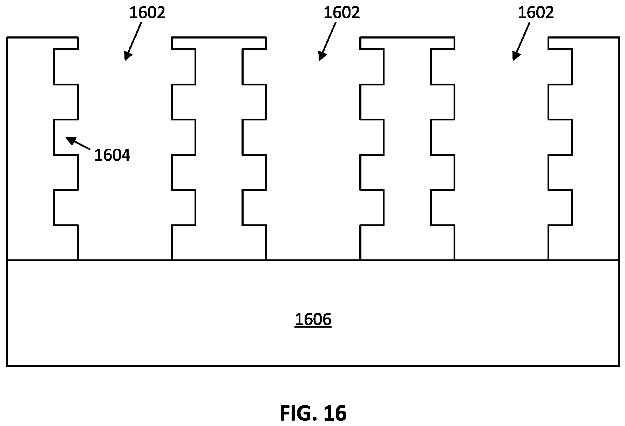

The surface area within the recesses of the trench MIM capacitor can be increased using various fabrication methods to increase the capacitance of the capacitor. Figure 16 illustrates one example of increasing the capacitor surface area within recesses 1602. According to some embodiments, recesses 1602 may be formed first using an RIE process to create similar recesses to those described above (e.g., similar to recesses 804). Afterwards, a lateral etch process may be used to form lateral recesses 1604 along the sidewalls of recesses 1602. The lateral etch may be performed in various ways. In one example, different material layers with high etch selectivity to one another are alternatingly deposited over a base dielectric 1606. Examples material layers can include silicon layers and silicon germanium layers. Once recesses 1602 have been formed, an isotropic etching process may be performed to etch lateral recesses 1604 in one type of material layer while etching little to none of the other type of material layer. Once the mold shape has been formed within the stack of alternating material layers, a sacrificial material can be formed within the mold and the alternating material layers can all be removed using any suitable isotropic etching process or processes and replaced with any number of dielectric materials. The sacrificial material may then be removed to yield the corrugated recess design. The trench capacitor electrodes and dielectric can be formed within the corrugated recesses using similar processes to those described above in Figures 9-11.

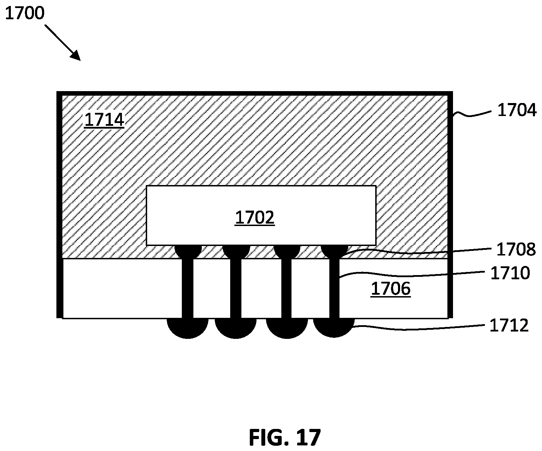

Figure 17 illustrates an example embodiment of a chip package 1700, in accordance with an embodiment of the present disclosure. As can be seen, chip package 1700 includes one or more dies 1702. One or more dies 1702 may include at least one integrated circuit having a structure as described in any of the aforementioned embodiments. One or more dies 1702 may include any other circuitry used to interface with other devices formed on the dies, or other devices connected to chip package 1700, in some example configurations.

As can be further seen, chip package 1700 includes a housing 1704 that is bonded to a package substrate 1706. The housing 1704 may be any standard or proprietary housing, and may provide, for example, electromagnetic shielding and environmental protection for the components of chip package 1700. The one or more dies 1702 may be conductively coupled to a package substrate 1706 using connections 1708, which may be implemented with any number of standard or proprietary connection mechanisms, such as solder bumps, ball grid array (BGA), pins, or wire bonds, to name a few examples. Package substrate 1706 may be any standard or proprietary package substrate, but in some cases includes a dielectric material having conductive pathways (e.g., including conductive vias and lines) extending through the dielectric material between the faces of package substrate 1706, or between different locations on each face. In some embodiments, package substrate 1706 may have a thickness less than 1 millimeter (e.g., between 0.1 millimeters and 0.5 millimeters), although any number of package geometries can be used. Additional conductive contacts 1712 may be disposed at an opposite face of package substrate 1706 for conductively contacting, for instance, a printed circuit board (PCB). One or more vias 1710 extend through a thickness of package substrate 1706 to provide conductive pathways between one or more of connections 1708 to one or more of contacts 1712. Vias 1710 are illustrated as single straight columns through package substrate 1706 for ease of illustration, although other configurations can be used (e.g., damascene, dual damascene, through-silicon via, or an interconnect structure that meanders through the thickness of substrate 1706 to contact one or more intermediate locations therein). In still other embodiments, vias 1710 are fabricated by multiple smaller stacked vias, or are staggered at different locations across package substrate 1706. In the illustrated embodiment, contacts 1712 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1712, to inhibit shorting.

In some embodiments, a mold material 1714 may be disposed around the one or more dies 1702 included within housing 1704 (e.g., between dies 1702 and package substrate 1706 as an underfill material, as well as between dies 1702 and housing 1704 as an overfill material). Although the dimensions and qualities of the mold material 1714 can vary from one embodiment to the next, in some embodiments, a thickness of mold material 1714 is less than 1 millimeter. Example materials that may be used for mold material 1714 include epoxy mold materials, as suitable. In some cases, the mold material 1714 is thermally conductive, in addition to being electrically insulating.

### Example System

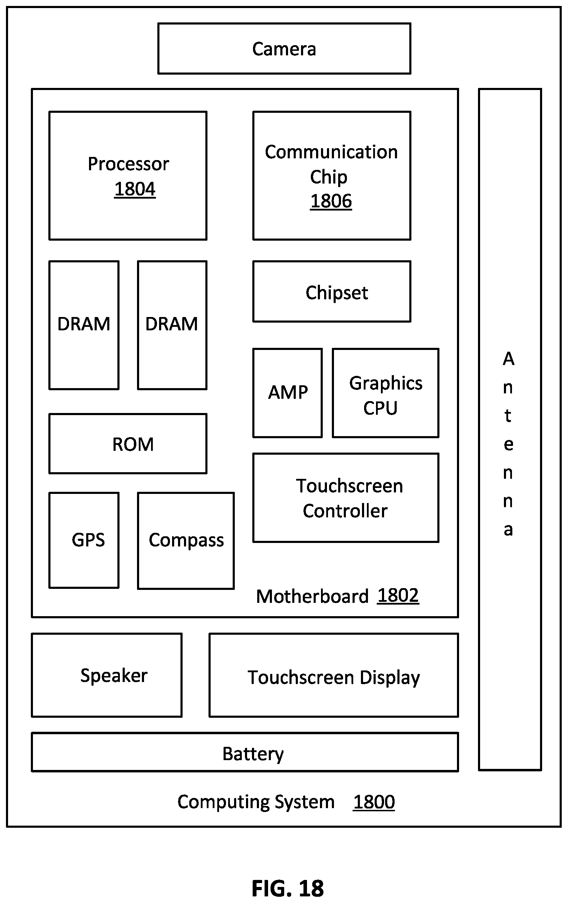

FIG. 18 is an example computing system implemented with one or more of the integrated circuit structures as disclosed herein, in accordance with some embodiments of the present disclosure. As can be seen, the computing system 1800 houses a motherboard 1802. The motherboard 1802 may include a number of components, including, but not limited to, a processor 1804 and at least one communication chip 1806, each of which can be physically and electrically coupled to the motherboard 1802, or otherwise integrated therein. As will be appreciated, the motherboard 1802 may be, for example, any printed circuit board (PCB), whether a main board, a daughterboard mounted on a main board, or the only board of system 1800, etc.

Depending on its applications, computing system 1800 may include one or more other components that may or may not be physically and electrically coupled to the motherboard 1802. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1800 may include one or more integrated circuit structures or devices configured in accordance with an example embodiment (e.g., a module including an integrated circuit having interconnect structures that have one or more MIM trench capacitors above corresponding planar MIM capacitors in the interconnect region). In some embodiments, multiple functions can be integrated into one or more chips (e.g., for instance, note that the communication chip 1806 can be part of or otherwise integrated into the processor 1804).

The communication chip 1806 enables wireless communications for the transfer of data to and from the computing system 1800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1806 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1800 may include a plurality of communication chips 1806. For instance, a first communication chip 1806 may be dedicated to shorter range wireless communications such as Wi-Fi and Bluetooth and a second communication chip 1806 may be dedicated to longer range wireless communications such as GPS, EDGE, GPRS, CDMA, WiMAX, LTE, Ev-DO, and others.

The processor 1804 of the computing system 1800 includes an integrated circuit die packaged within the processor 1804. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1806 also may include an integrated circuit die packaged within the communication chip 1806. In accordance with some such example embodiments, the integrated circuit die of the communication chip includes one or more semiconductor devices as variously described herein. As will be appreciated in light of this disclosure, note that multistandard wireless capability may be integrated directly into the processor 1804 (e.g., where functionality of any chips 1806 is integrated into processor 1804, rather than having separate communication chips). Further note that processor 1804 may be a chip set having such wireless capability. In short, any number of processor 1804 and/or communication chips 1806 can be used. Likewise, any one chip or chip set can have multiple functions integrated therein.

In various implementations, the computing system 1800 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1800 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a plurality of semiconductor devices, an interconnect region above or below the plurality of semiconductor devices and having a plurality of interconnect layers, a first metal-insulator-metal (MIM) capacitor in at least one interconnect layer of the plurality of interconnect layers, and a second MIM capacitor in one of the at least one interconnect layer. The first MIM capacitor includes a first electrode running along sidewalls and top surfaces of a plurality of parallel dielectric fins, a first capacitor dielectric layer on the first electrode, and a second electrode on the first capacitor dielectric layer. The first capacitor dielectric layer follows the first electrode along the sidewalls and the top surfaces of the plurality of parallel dielectric fins, and the second electrode follows the first capacitor dielectric layer along the sidewalls and the top surfaces of the plurality of parallel dielectric fins. The second MIM capacitor includes a first planar electrode, a second capacitor dielectric layer on the first planar electrode, and a second planar electrode on the second capacitor dielectric layer.

Example 2 includes the integrated circuit of Example 1, wherein each of the plurality of parallel dielectric fins have a height of at least 300 nm.

Example 3 includes the integrated circuit of Example 1 or 2, wherein the at least one interconnect layer comprises a layer of dielectric material, and the plurality of parallel dielectric fins are part of the layer of dielectric material.

Example 4 includes the integrated circuit of Example 3, wherein the top surfaces of the plurality of parallel dielectric fins are substantially coplanar with a top surface of the layer of dielectric material.

Example 5 includes the integrated circuit of Example 3 or 4, wherein the first electrode extends along a top surface of the layer of dielectric material on one side of the plurality of parallel dielectric fins and the second electrode extends along a top surface of the layer of dielectric material on an opposite side of the plurality of parallel dielectric fins.

Example 6 includes the integrated circuit of Example 5, further comprising a first conductive layer and a second conductive layer, both beneath the first and second MIM capacitors, wherein a first conductive via extends from the first electrode on the top surface of the layer of dielectric material to the first conductive layer, and a second conductive via extends from the second electrode on the top surface of the layer of dielectric material to the second conductive layer.

Example 7 includes the integrated circuit of Example 6, further comprising a third conductive layer and a fourth conductive layer, both beneath the first and second MIM capacitors, wherein a third conductive via extends from the first planar electrode to the third conductive layer, and a fourth conductive via extends from the second planar electrode to the fourth conductive layer.

Example 8 includes the integrated circuit of any one of Examples 1-7, wherein the at least one interconnect layer comprises a first layer of dielectric material, and the plurality of parallel dielectric fins are part of the first layer of dielectric layer. The integrated circuit further includes a conductive layer beneath the first MIM capacitor and in contact with the first electrode, and a second layer of dielectric material under the conductive layer and in contact with both the conductive layer and the second planar electrode.

Example 9 includes the integrated circuit of Example 8, wherein the dielectric material of the first layer is compositionally distinct from the dielectric material of the second layer.

Example 10 includes the integrated circuit of Example 8 or 9, wherein the dielectric material of the second layer and dielectric material of the first and second capacitor dielectric layers are the same material.

Example 11 includes the integrated circuit of any one of Examples 1-10, wherein the at least one interconnect layer comprises a first layer of dielectric material, and the plurality of parallel dielectric fins are part of the first layer of dielectric layer. The integrated circuit further includes a second layer of dielectric material beneath the first MIM capacitor and in contact with the first electrode and the second planar electrode. The dielectric material of the first layer is compositionally distinct from the dielectric material of the second layer.

Example 12 includes the integrated circuit of any one of Examples 1-11, wherein the interconnect region is above the plurality of semiconductor devices and the at least one interconnect layer is one of the three topmost interconnect layers of the plurality of interconnect layers.

Example 13 includes the integrated circuit of any one of Examples 1-12, wherein the first and second capacitor dielectric layers each includes a high-k dielectric.

Example 14 includes the integrated circuit of any one of Examples 1-13, wherein the first MIM capacitor is in more than one interconnect layer of the plurality of interconnect layers.

Example 15 includes the integrated circuit of any one of Examples 1-13, wherein the first MIM capacitor and the second MIM capacitor are in a same single interconnect layer.

Example 16 includes the integrated circuit of any one of Examples 1-15, wherein the plurality of parallel dielectric fins include lateral recesses along the sidewalls, and the first electrode runs along inner surfaces of the lateral recesses of the parallel dielectric fins.

Example 17 is a printed circuit board that includes the integrated circuit of any one of Examples 1-16.

Example 18 is an electronic device that includes a chip package having one or more dies. At least one of the one or more dies includes an interconnect region above a plurality of semiconductor devices and having a plurality of interconnect layers, and a first metal-insulator-metal (MIM) capacitor in at least one interconnect layer of the plurality of interconnect layers. The first MIM capacitor includes a first electrode running along sidewalls and top surfaces of a plurality of parallel dielectric fins, a first capacitor dielectric layer on the first electrode, and a second electrode on the first capacitor dielectric layer. The first capacitor dielectric layer follows the first electrode along the sidewalls and the top surfaces of the plurality of parallel dielectric fins, and the second electrode follows the first capacitor dielectric layer along the sidewalls and the top surfaces of the plurality of parallel dielectric fins. The at least one of the one or more dies further includes a second MIM capacitor in one of the at least one interconnect layers and beneath the plurality of parallel dielectric fins. The second MIM capacitor includes a first planar electrode, a second capacitor dielectric layer on the first planar electrode, and a second planar electrode on the second capacitor dielectric layer.

Example 19 includes the electronic device of Example 18, wherein each of the plurality of parallel dielectric fins have a height of at least 300 nm.

Example 20 includes the electronic device of Example 18 or 19, wherein the at least one interconnect layer comprises a layer of dielectric material and the plurality of parallel dielectric fins are part of the layer of dielectric material.

Example 21 includes the electronic device of Example 20, wherein the top surfaces of the plurality of parallel dielectric fins are substantially coplanar with a top surface of the layer of dielectric material.

Example 22 includes the electronic device of Example 20 or 21, wherein the first electrode extends along a top surface of the layer of dielectric material on one side of the plurality of parallel dielectric fins and the second electrode extends along a top surface of the layer of dielectric material on an opposite side of the plurality of parallel dielectric fins.

Example 23 includes the electronic device of Example 22, wherein the at least one of the one or more dies further comprises a first conductive layer and a second conductive layer, both beneath the first and second MIM capacitors, wherein a first conductive via extends from the first electrode on the top surface of the layer of dielectric material to the first conductive layer, and a second conductive via extends from the second electrode on the top surface of the layer of dielectric material to the second conductive layer.

Example 24 includes the electronic device of Example 23, wherein the at least one of the one or more dies further comprises a third conductive layer and a fourth conductive layer, both beneath the first and second MIM capacitors, wherein a third conductive via extends from the first planar electrode to the third conductive layer, and a fourth conductive via extends from the second planar electrode to the fourth conductive layer.

Example 25 includes the electronic device of any one of Examples 18-24, wherein the at least one interconnect layer comprises a first layer of dielectric material, and the plurality of parallel dielectric fins are part of the first layer of dielectric layer. The at least one of the one or more dies further comprises a conductive layer beneath the first MIM capacitor and in contact with the first electrode, and a second layer of dielectric material under the conductive layer and in contact with both the conductive layer and the second planar electrode.

Example 26 includes the electronic device of Example 25, wherein the dielectric material of the first layer is compositionally distinct from the dielectric material of the second layer.

Example 27 includes the electronic device of Example 25 or 26, wherein the dielectric material of the second layer and dielectric material of the first and second capacitor dielectric layers are the same material.

Example 28 includes the electronic device of any one of Examples 18-27, wherein the interconnect layer comprises a first layer of dielectric material, and the plurality of parallel dielectric fins are part of the first layer of dielectric layer. The at least one of the one or more dies further comprises a second layer of dielectric material beneath the first MIM capacitor and in contact with the first electrode and the second planar electrode. The dielectric material of the first layer is compositionally distinct from the dielectric material of the second layer.

Example 29 includes the electronic device of any one of Examples 18-28, wherein the interconnect layer is one of the three topmost interconnect layers of the plurality of interconnect layers.

Example 30 includes the electronic device of any one of Examples 18-29, wherein the first and second capacitor dielectric layers each includes a high-k dielectric.

Example 31 includes the electronic device of any one of Examples 18-30, wherein the first MIM capacitor is in more than one interconnect layer of the plurality of interconnect layers.

Example 32 includes the electronic device of any one of Examples 18-30, wherein the first MIM capacitor and the second MIM capacitor are in a same single interconnect layer.

Example 33 includes the electronic device of any one of Examples 18-32, wherein the plurality of parallel dielectric fins include lateral recesses along the sidewalls, and the first electrode runs along inner surfaces of the lateral recesses of the parallel dielectric fins.

Example 34 includes the electronic device of any one of Examples 18-33, further comprising a printed circuit board, wherein the chip package is attached to the printed circuit board.

Example 35 is an integrated circuit that includes an interconnect layer of a plurality of interconnect layers and having a dielectric layer, a first MIM capacitor at least partially in the dielectric layer and having at least one electrode on sidewalls and top surfaces of a plurality of parallel dielectric fins, and a second MIM capacitor in the dielectric layer below the first MIM capacitor. The second MIM capacitor includes a first planar electrode, a second capacitor dielectric layer on the first planar electrode, and a second planar electrode on the second capacitor dielectric layer.

Example 36 includes the integrated circuit of Example 35, wherein the dielectric layer has a thickness of at least 300 nm.

Example 37 includes the integrated circuit of Example 35 or 36, wherein the top surfaces of the plurality of parallel dielectric fins are substantially coplanar with a top surface of the dielectric layer.

Example 38 includes the integrated circuit of any one of Examples 35-37, wherein the first MIM capacitor comprises a first electrode on the sidewalls and the top surfaces of the plurality of parallel dielectric fins, a capacitor dielectric layer on the first electrode, such that the capacitor dielectric layer follows the first electrode along the sidewalls and the top surfaces of the plurality of parallel dielectric fins, and a second electrode on the capacitor dielectric layer, such that the second electrode follows the capacitor dielectric layer along the sidewalls and the top surfaces of the plurality of parallel dielectric fins.

Example 39 includes the integrated circuit of Example 38, wherein the first electrode extends along a top surface of the dielectric layer on one side of the plurality of parallel dielectric fins and the second electrode extends along a top surface of the dielectric layer on an opposite side of the plurality of parallel dielectric fins.

Example 40 includes the integrated circuit of Example 39, further comprising a first conductive layer and a second conductive layer, both beneath the first and second MIM capacitors, wherein a first conductive via extends from the first electrode on the top surface of the dielectric layer to the first conductive layer, and a second conductive via extends from the second electrode on the top surface of the dielectric layer to the second conductive layer.

Example 41 includes the integrated circuit of Example 40, further comprising a third conductive layer and a fourth conductive layer, both beneath the first and second MIM capacitors, wherein a third conductive via extends from the first planar electrode to the third conductive layer, and a fourth conductive via extends from the second planar electrode to the fourth conductive layer.

Example 42 includes the integrated circuit of any one of Examples 35-41, wherein the dielectric layer comprises a first dielectric layer, and the integrated circuit further includes: a conductive layer beneath the first MIM capacitor and in contact with the at least one electrode of the first MIM capacitor; and a second dielectric layer under the conductive layer and in contact with both the conductive layer and the second planar electrode of the second MIM capacitor.

Example 43 includes the integrated circuit of Example 42, wherein dielectric material of the first dielectric layer is compositionally distinct from dielectric material of the second dielectric layer.

Example 44 includes the integrated circuit of Example 42 or 43, wherein dielectric material of the second dielectric layer is the same as a dielectric material of the capacitor dielectric layer of the second MIM capacitor and/or a dielectric material of a capacitor dielectric layer of the first MIM capacitor.

Example 45 includes the integrated circuit of any one of Examples 35-44, wherein the dielectric layer comprises a first dielectric layer, and the plurality of parallel dielectric fins are part of the first dielectric layer, and the integrated circuit further includes a second dielectric layer beneath the first MIM capacitor and in contact with the first electrode and the second planar electrode. The dielectric material of the first dielectric layer is compositionally distinct from dielectric material of the second dielectric layer.

Example 46 includes the integrated circuit of any one of Examples 35-45, wherein the interconnect layer is one of the three topmost interconnect layers of the plurality of interconnect layers.

Example 47 includes the integrated circuit of any one of Examples 35-46, wherein the capacitor dielectric layer includes a high-k dielectric.

Example 48 includes the integrated circuit of any one of Examples 35-47, wherein the plurality of parallel dielectric fins include lateral recesses along the sidewalls, and the first electrode runs along inner surfaces of the lateral recesses of the parallel dielectric fins.

Example 49 is a printed circuit board that includes the integrated circuit of any one of Examples 35-48.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit, comprising:
a plurality of semiconductor devices;
an interconnect region above or below the plurality of semiconductor devices, the interconnect region comprising a plurality of interconnect layers;
a first metal-insulator-metal (MIM) capacitor in at least one interconnect layer of the
plurality of interconnect layers, the first MIM capacitor comprising a first electrode running along sidewalls and top surfaces of a plurality of parallel dielectric fins,
a first capacitor dielectric layer on the first electrode, such that the first capacitor dielectric layer follows the first electrode along the sidewalls and the top surfaces of the plurality of parallel dielectric fins, and
a second electrode on the first capacitor dielectric layer, such that the second electrode follows the first capacitor dielectric layer along the sidewalls and the top surfaces of the plurality of parallel dielectric fins; and
a second MIM capacitor in one of the at least one interconnect layer, the second MIM
capacitor comprising
a first planar electrode,
a second capacitor dielectric layer on the first planar electrode, and
a second planar electrode on the second capacitor dielectric layer.

2. The integrated circuit of claim 1, wherein each of the plurality of parallel dielectric fins have a height of at least 300 nm.

3. The integrated circuit of claim 1 or 2, wherein the at least one interconnect layer comprises a layer of dielectric material, and the plurality of parallel dielectric fins are part of the layer of dielectric material.

4. The integrated circuit of claim 3, wherein the top surfaces of the plurality of parallel dielectric fins are substantially coplanar with a top surface of the layer of dielectric material.

5. The integrated circuit of claim 3 or 4, wherein the first electrode extends along a top surface of the layer of dielectric material on one side of the plurality of parallel dielectric fins and the second electrode extends along a top surface of the layer of dielectric material on an opposite side of the plurality of parallel dielectric fins.

6. The integrated circuit of claim 5, further comprising a first conductive layer and a second conductive layer, both beneath the first and second MIM capacitors, wherein a first conductive via extends from the first electrode on the top surface of the layer of dielectric material to the first conductive layer, and a second conductive via extends from the second electrode on the top surface of the layer of dielectric material to the second conductive layer.

7. The integrated circuit of claim 6, further comprising a third conductive layer and a fourth conductive layer, both beneath the first and second MIM capacitors, wherein a third conductive via extends from the first planar electrode to the third conductive layer, and a fourth conductive via extends from the second planar electrode to the fourth conductive layer.

8. The integrated circuit of any one of claims 1 through 7, wherein the at least one interconnect layer comprises a first layer of dielectric material, and the plurality of parallel dielectric fins are part of the first layer of dielectric layer, the integrated circuit further comprising:
a conductive layer beneath the first MIM capacitor and in contact with the first electrode; and
a second layer of dielectric material under the conductive layer and in contact with both the conductive layer and the second planar electrode.

9. The integrated circuit of claim 8, wherein the dielectric material of the first layer is compositionally distinct from the dielectric material of the second layer, and/or the dielectric material of the second layer and dielectric material of the first and second capacitor dielectric layers are the same material.

10. The integrated circuit of any one of claims 1 through 9, wherein the at least one interconnect layer comprises a first layer of dielectric material, and the plurality of parallel dielectric fins are part of the first layer of dielectric layer, and wherein integrated circuit further includes a second layer of dielectric material beneath the first MIM capacitor and in contact with the first electrode and the second planar electrode, the dielectric material of the first layer being compositionally distinct from the dielectric material of the second layer.

11. The integrated circuit of any one of claims 1 through 10, wherein the interconnect region is above the plurality of semiconductor devices and the at least one interconnect layer is one of the three topmost interconnect layers of the plurality of interconnect layers.

12. The integrated circuit of any one of claims 1 through 11, wherein the first MIM capacitor is in more than one interconnect layer of the plurality of interconnect layers.

13. The integrated circuit of any one of claims 1 through 11, wherein the first MIM capacitor and the second MIM capacitor are in a same single interconnect layer.

14. The integrated circuit of any one of claims 1 through 13, wherein the plurality of parallel dielectric fins include lateral recesses along the sidewalls, and the first electrode runs along inner surfaces of the lateral recesses of the parallel dielectric fins.

15. A printed circuit board comprising the integrated circuit of any one of claims 1 through 14.
